# EUROPEAN PATENT SPECIFICATION

(11) **EP 2 871 919 B1**
(45) Date of publication and mention of the grant of the patent: **27.09.2017**
(21) Application number: 13812933.3
(22) Date of filing: 03.07.2013
(51) Int. Cl.: H05K 3/42, H05K 3/18, B29C 45/00, H05K 3/10, H05K 1/11, H05K 1/02

(54) **STRUCTURE**
STRUKTUR
STRUCTURE

(30) Priority: 06.07.2012 JP 2012153107; 09.07.2012 JP 2012154170
(43) Date of publication of application: 13.05.2015
(73) Proprietor: Sharp Kabushiki Kaisha, Osaka-shi, Osaka 545-8522 (JP)
(72) Inventor: OKAJIMA, Yuhsuke, Osaka-shi, Osaka 545-8522 (JP); TAKEBE, Hiroyuki, Osaka-shi, Osaka 545-8522 (JP); KATAYAMA, Tomofumi, Osaka-shi, Osaka 545-8522 (JP)
(74) Representative: Müller Hoffmann & Partner
(86) International application number: PCT/JP2013/068269
(87) International publication number: WO 2014/007292

(56) References cited:
- EP-A2- 2 076 106
- WO-A1-97/13295
- JP-A- H03 206 681
- JP-A- H05 218 659
- JP-A- H07 169 542
- JP-A- H09 115 577
- JP-A- 2001 044 588
- JP-A- 2003 133 727
- US-A1- 2003 150 645
- US-A1- 2007 039 754
- US-A1- 2010 084 178

## Description

### Technical Field

The present invention relates to a structure provided with a conductive body.

### Background Art

There has been a disclosure regarding a technique of electrically connecting a front surface and a back surface of a molded object having a through hole, by forming a conductive body extending through the through hole of the molded object.

For example, Patent Literature 1 discloses a method of electrically connecting a front surface and a back surface of an insulating substrate. This electric connection is made by first forming a conductive film in a through hole of the insulating substrate, then, filling the through hole with a conductive paste, and further plating a surface of the through hole.

### Citation List

### Patent Literature

Patent Literature 1
Japanese Patent Application Publication, Tokukai, No. 2012-28623 (Publication Date: February 9, 2012)

### Non-Patent Literature

Non-Patent Literature 1
LPKF, "Designing three-dimensional circuitry bodies (MIDs)", obtained on June 7, 2012, from http://www.lpkfusa.com/mid/lasersystems.htm

### Summary of Invention

### Technical Problem

However, in the case of the technique of Patent Literature 1, in some cases, a front surface and the back surface of a molded object are electrically disconnected. For example, in the case of the technique of Patent Literature 1, when an external pressure is applied to a through hole of an insulating substrate, a force is applied to an attachment part between the insulating substrate and a conductive paste that is filled in the through hole. In a case where the external pressure is greater than an adhesion force between the conductive paste and the insulating substrate, the conductive paste is displaced relative to the insulating substrate. This may cause a crack to the front surface of the insulating substrate, along an outer shape of the conductive paste. Further, the above displacement may cause peel-off of the conductive paste from a conductive film that is formed in the through hole. As a result, in the technique of Patent Literature 1, electrical connection cannot be maintained between the front surface and the back surface of the insulating substrate.

WO 97/13295 A1 discloses an electrical connector with multiple through holes extending through an insulating sheet. Conducting material is lining the through holes, deformable material is provided in the through holes. On ends of the deformable material, conducting contact members are provided. These deform the deformable material when pressure is applied on the contact members.

US 2003/0150645 A1 discloses a method and an apparatus for coupling a microelectronic device package to a circuit board. The printed circuit board is filled with a malleable electrically conductive material such as an elastomer containing a concentration of conductive particles. The material in each through hole forms an electrical contact at which a solder ball or pin of a ball grid array or pin grid array of a microelectronic package will be coupled to the printed circuit board.

US 2010/0084178 A1 relates to vias provided on a printed circuit board with at least one additional depression encompassing the via such that the via passes through a portion of the depression.

EP 2 076 106 A2 relates to a multilayer wiring board manufactured by preparing a first wiring board, a second wiring board, and a joint sheet in between, wherein through-holes in the two wiring boards and the joint sheet are matching.

The present invention is attained in view of the above problem. A main object of the present invention is to provide a structure capable of maintaining electrical connection even in a case where an external pressure is applied.

### Solution to Problem

In order to solve the above problem, a structure of the present invention according to claim 1 is provided. The structure includes: an insulating body having a first through hole; a conductive body electrically connecting two surfaces having respective openings of the first through hole, the conductive body being provided on an inner wall of the first through hole; and a filler being filled in the first through hole, the filler being made of a substance that is deformed by an external pressure more easily than the insulating body.

### Advantageous Effects of Invention

A structure of the present invention includes: an insulating body having a first through hole; a conductive body electrically connecting two surfaces having respective openings of the first through hole, the conductive body being provided on an inner wall of the first through hole; and a filler being filled in the first through hole, the filler being made of a substance that is deformed by an external pressure more easily than the insulating body.

This allows the structure to maintain electrical connection between two surfaces respectively having openings of the first through hole.

### Brief Description of Drawings

Fig. 1 is a lateral cross-sectional view illustrating an example of a structure according to one embodiment (Embodiment 1) of the present invention.
Fig. 2 is a view illustrating one example of a change in an elastic body at the time when an external pressure is applied to the structure of Fig. 1.
Fig. 3 is a lateral cross-sectional view illustrating an example of a structure according to one embodiment (Embodiment 2) of the present invention.
Fig. 4 is a lateral cross-sectional view illustrating another example of a structure according to one embodiment (Embodiment 2) of the present invention.
Fig. 5 is a lateral cross-sectional view illustrating an example of a structure according to one embodiment (Embodiment 3) of the present invention.
Fig. 6 is a view illustrating one example of a structure according to one embodiment (Embodiment 3) of the present invention.
Fig. 7 is an enlarged view of a portion circled in the structure of Fig. 6.
   (a) of Fig. 8 is a cross sectional view of a plane taken along a broken line in the structure of Fig. 7. (b) of Fig. 8 is a perspective view of a back surface of the structure 30 of Fig. 7. (c) of Fig. 8 is a perspective view of a front surface of the structure 30 of Fig. 7.
Fig. 9 is a lateral cross-sectional view illustrating another example of a structure according to one embodiment (Embodiment 3) of the present invention.
Fig. 10 is a lateral cross-sectional view illustrating another example of a structure according to one embodiment (Embodiment 3) of the present invention.
   (a) to (d) of Fig. 11 each are a view schematically illustrating a variation of a conduction pattern according to one embodiment of the present invention.
Fig. 12 is a lateral cross-sectional view illustrating another example of a structure according to one embodiment of the present invention.

### Description of Embodiments

### [Embodiment 1]

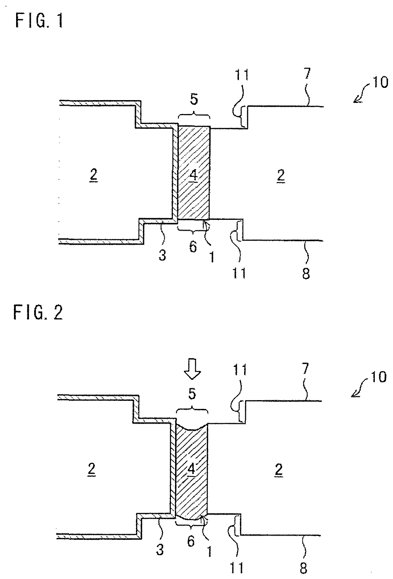

Fig. 1 is a lateral cross-sectional view illustrating an example of a structure according to one embodiment (Embodiment 1) of the present invention. As illustrated in Fig. 1, a structure 10 according to Embodiment 1 includes a molded object (insulating body) 2 having a through hole (first through hole) 1, a conduction pattern (conductive body) 3 provided on the molded object 2 and extending through the through hole 1, and an elastic body (filler) 4 filled in the through hole 1.

### (Molded Object)

In the present specification, a molded object means an insulating resin structure molded into a given shape by use of a mold, or the like. The molded object 2 is not specifically limited in shape. In view of processing, the shape may be a plate-like shape or a bent-plate-like shape that allows a thickness of the molded object 2 to be substantially uniform by offsetting the shape of a surface of one side of the molded object. Note, however, that the molded object 2 may have a portion that is greater in thickness than the other portions, and in such a case, a part of the shape of the molded object may have a depression in the portion that is greater in thickness so that the thickness of the above portion of the molded object becomes substantially the same as the thickness of portions around the above portion (in a technical term in the field of molding, such a technique is called relief).

In the molded object 2, the through hole 1 is provided so as to penetrate the molded object 2 in a thickness direction. For convenience of explanation, respective surfaces having openings of the through hole 1 in the molded object 2 are referred to as a front surface 7 and a back surface 8. Further, in the molded object 2, depressions (first depressions) 11 are provided. These depressions are depressed inward from the respective surfaces (the front surface 7 and the back surface 8) of the molded object 2. The through hole 1 is formed so that the openings are provided in the depressions 11, respectively. For convenience of explanation, an opening of the through hole 1 on a front surface 7 side is referred to as an opening 5, while an opening of the through hole 1 on a back surface 8 side is referred to as an opening 6. The shapes of the depressions 11 are not specifically limited. The shapes of the depressions 11 each can be a circular shape, or may alternatively be, for example, an ellipsoidal shape, a polygonal shape (including a triangular shape and a rectangular shape), or a combined shape of a circular shape or an ellipsoidal shape and a polygonal shape.

A material constituting the molded object 2 can be, for example, resin, glass, or ceramics. However, the material of the molded object 2 is not limited to these material.

### (Conduction Pattern)

In the present specification, the conduction pattern means a film-like or plate-like conductive body formed into a given shape. The conduction pattern 3 is provided on the molded object 2, and extends from the front surface 7 to the back surface 8 of the molded object 2 through the through hole 1. In other words, the conduction pattern 3 is provided on an inner wall of the through hole 1, and electrically connects the two surfaces (the front surface 7 and the back surface 8) having the openings of the through hole 1.

In one aspect, the conduction pattern 3 can be formed by using an LDS (Laser Direct Structuring) method as described in Non-Patent Literature 1. That is, the conduction pattern 3 can be formed by: first, mixing an organic metal in a resin constituting the molded object 2; and then, carrying out laser irradiation on a region where the conduction pattern 3 is to be formed on the molded object 2. As a result of the laser irradiation, a plating is deposited on a section where the laser irradiation is carried out, or the section where the laser irradiation becomes rough at a fine level and consequently, a plating is bound to the section where the laser irradiation is carried out. This results in formation of the conduction pattern 3.

A material of the conduction pattern 3 is not specifically limited. As such a material, any conductive substance (e.g., metal such as copper plating or nickel plating) may be used.

### (Through Hole)

In the present specification, the through hole means a hole penetrating the molded object in a thickness direction. The shape of each opening of the through hole 1 is not specifically limited. The shape of each opening may be a circular shape, or may alternatively be, for example, an ellipsoidal shape, a polygonal shape (including a triangular shape or a rectangular shape), or a combined shape of a circular shape or an ellipsoidal shape and a polygonal shape.

### (Elastic Body)

In the present specification, the elastic body means a member made of a substance that can be deformed more easily in response to an external pressure than the molded object 2. Preferably, the elastic body is made of a substance that has a higher Young's modulus than the molded object 2. Examples of the substance constituting the elastic body 4 encompass silicone, rubber, and elastomer such as synthetic rubber. However, the substance constituting the elastic body 4 is not limited to these substances. The elastic body 4 is filled in the through hole 1 as illustrated in Fig. 1. Further, regarding adhesion of the elastic body 4 and the molded object 2, the elastic body 4 itself may be elastic or a separate adhesive material may be used so as to bond the elastic body 4 to the molded object 2. In addition, the elastic body 4 may be an insulating material or may also be a conductive material.

Fig. 2 is a view illustrating one example of a motion of the elastic body 4 at the time when an external pressure is applied to the structure 10. As illustrated in Fig. 2, when a pressure (external pressure) is applied to the structure 10 from above the structure 10, a center portion (a portion farther from the inner wall of the through hole 1) of the elastic body 4 deforms in a direction in which the pressure is applied. In the case of Fig. 2, the elastic body 4 deforms downward. Meanwhile, a portion (a portion closer to the inner wall of the through hole 1) of the elastic body 4 which portion adheres to the conduction pattern 3 substantially does not deform.
As described above, the elastic body 4 is made of a member whose portion farther from the inner wall of the through hole 1 deforms more as compared to a portion closer to the inner wall of the through hole 1 at the time when an external pressure is applied to the elastic body 4. As a result, force concentrates on the portion of the elastic body 4 which portion is farther from the inner wall of the through hole 1, while substantially no force is applied to the portion of the elastic body 4 which portion is closer to the inner wall of the through hole 1. Accordingly, the portion of the elastic body 4 which portion is closer to the inner wall of the through hole 1 substantially does not deform. Therefore, a shear is not produced between the conduction pattern 3 and the elastic body 4. Consequently, the conduction pattern 3 and the elastic body 4 are not detached from each other. This makes it possible to prevent disconnection of the conduction pattern 3. As a result, electrical connection between the front surface 7 and the back surface 8 of the molded object can be maintained.

Further, as illustrated in Fig. 2, the molded object 2 has the depression 11. Accordingly, when the elastic body 4 deforms, it is possible to prevent protrusion of the elastic body 4 from the back surface 8 (or front surface 7) of the molded object 2. Therefore, even in a case where an external component 14 is provided in the vicinity of the opening of the through hole 1, it is possible to prevent a contact (interference) between the external component and the elastic body 4.

### (Applications of Conduction Pattern)

In Embodiment 1, the conduction pattern 3 can be used for various applications.

For example, in one aspect, the conduction pattern 3 can be used as an antenna. That is, the conduction pattern 3 can be used as an antenna by providing, on the front surface 7 side or the back surface 8 side, a feeding section 13 for the conduction pattern 3.

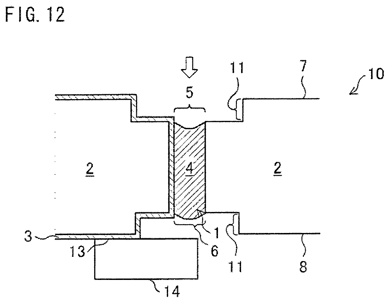

The feeding section 13 may be provided to any position on the molded object 2 except positions of the depression 11 and the through hole 1. For example, the feeding section 13 may be provided at a position, as illustrated in Fig. 12, on the conductive patter 3. In such a structure, even in a case where the external component 14 as the power feeding member is present in the vicinity of the opening of the through hole 1 (note, however, that the external component 14 does not enter the depression 11), the elastic body 4 that deforms never protrudes from the back surface 8 (or the front surface 7) of the molded object 2. Accordingly, even when an external pressure is applied, a physical contact between the elastic body 4 and the external component 14 connected to the feeding section 13 can be prevented.

Further, in another aspect, the conduction pattern 3 can be used for electrically connecting the front surface 7 and the back surface 8 of the molded object 2. For example, by (i) providing, as the external component 14, a ground made of a plate or the like on the front surface 7 side, and also providing, as the external component 14, a circuit substrate on the back surface 8 side, and (ii) connecting the conduction pattern 3 on the front surface 7 side with the ground made of a plate or the like, and also connecting the conduction pattern 3 on the back surface 8 side with the circuit substrate, the ground and the circuit substrate can be connected via the conduction pattern 3.

A connection between the conduction pattern 3 and the external component 14 (e.g., a ground made of a plate or the like) on the front surface 7 side and a connection between the conduction pattern 3 and the external component 14 (e.g., a circuit substrate) on the back surface 8 side each may be formed at any position on the molded object 2 except the positions in the depression 11 and the through hole 1. In this structure, even in a case where the external component 14 is provided in the vicinity of the opening of the through hole 1 and the elastic body 4 deforms, the deformed elastic body 4 never protrudes from the back surface 8 (or the front surface 7) of the molded object 2. Therefore, even when an external pressure is applied, it is possible to prevent a physical contact between the elastic body 4 and the external component 14 connected to the back surface 8 (or the front surface 7). In addition, such a connection may be provided to either one of the front surface 7 and the back surface 8.

In addition, in a still another aspect, the conduction pattern 3 may be used for preventing static electricity.

### [Embodiment 2]

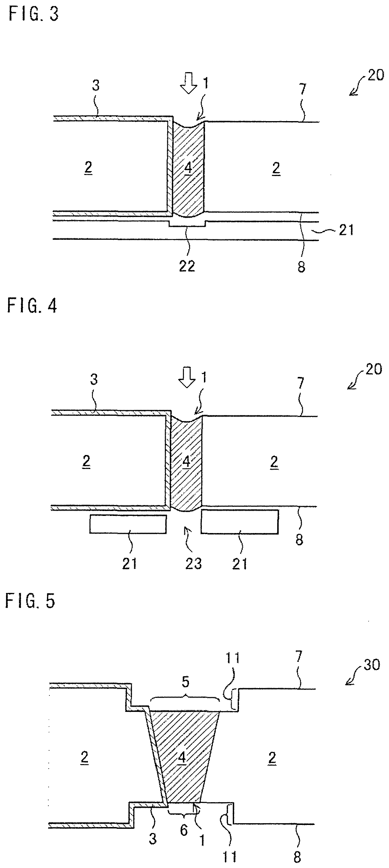

Fig. 3 is a lateral cross-sectional view illustrating an example of a structure according to another embodiment (Embodiment 2) of the present invention. The structure 10 according to Embodiment 1 is provided with the depressions 11 that are depressed inward from respective surfaces (the front surface 7 and the back surface 8) of the molded object 2. In a structure 20 according to Embodiment 2, such a depression in Embodiment 1 is provided to a member (corresponding to a "separate member" in Claims) made of an insulating body that is different from the molded object 2. Embodiment 2 is different from Embodiment 1 only in this point. Accordingly, the following discusses only this difference. Further, identical members are given identical reference signs and explanations thereof are omitted here.

As illustrated in Fig. 3, the structure 20 according to Embodiment 2 includes a member 21 made of an insulating body having a depression (second depression) 22. The member 21 is provided so that the depression 22 of the member 21 faces the through hole 1 of the molded object 2. The depression 22 of the member 21 is formed so as to have a width that is the same as or greater than that of the opening of the through hole 1. The member 21 1 is not limited to an insulating body, but may alternatively be a conductive object. Further, the member 21 is not necessarily a single body, but may alternatively be a set of a plurality of objects.

As described above, provision of the member 21 with the depression 22 makes it possible to prevent the elastic body 4 from having a contact (interfering) with the member 21 at the time when the elastic body 4 deforms.

Further, the member 21 may be arranged to have not the depression 22 but a through hole. Fig. 4 is a lateral cross-sectional view illustrating another example of a structure according to another embodiment of the present invention. As illustrated in Fig. 4, a member 21 has a through hole (second through hole) 23. The structure as illustrated in Fig. 4 is different only in this point from the structure illustrated in Fig. 3.

By providing the through hole 23 in the member 21 as described above, it is possible to prevent the elastic body 4 from having a contact (interfering) with the member 21 at the time when the elastic body 4 deforms.

Alternatively, it is possible to provide no member (e.g., the member 21) that is different from the molded object 2, at a position facing the through hole. This arrangement also makes it possible to prevent the elastic body 4 from having a contact (interfering) with another member.

Embodiment 2 has discussed an arrangement where the structure 20 is arranged not to have the depressions 11 on the surfaces (the front surface 7 and the back surface 8) of the molded object 2. However, the present invention is not limited to this arrangement. In other words, the structure 20 may be arranged to have a depression 11 on a surface (the front surface 7 and the back surface 8) of the molded object 2.

### [Embodiment 3]

Fig. 5 is a lateral cross-sectional view illustrating an example of a structure according to another embodiment (Embodiment 3) of the present invention. In Embodiments 1 and 2, the through hole 1 has a shape having a uniform width. Meanwhile, a structure 30 according to Embodiment 3 has a shape whose inner wall is inclined. Embodiment 3 is different only in this point from embodiments 1 and 2. Accordingly, the following discusses only this difference. Further, identical members are given identical reference signs and explanations thereof are omitted here.

As illustrated in Fig. 5, a through hole 1 of the structure 30 according to Embodiment 3 has an incline. Due to the incline, the through hole 1 has a shape tapering from an opening 5 towards an opening 6. Because the inner wall of the through hole 1 is inclined as described above, an elastic body 4 can be easily filled.

Further, in a case where the conduction pattern 3 is formed by an LDS method as described in Non-Patent Literature 1, it becomes easy to carry out laser irradiation. This makes it possible to precisely adjust the conduction pattern 3 in the through hole 1.

### (Example)

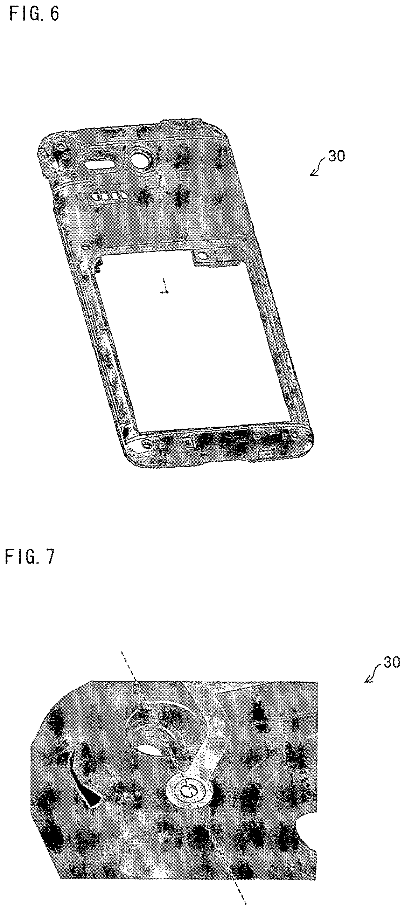

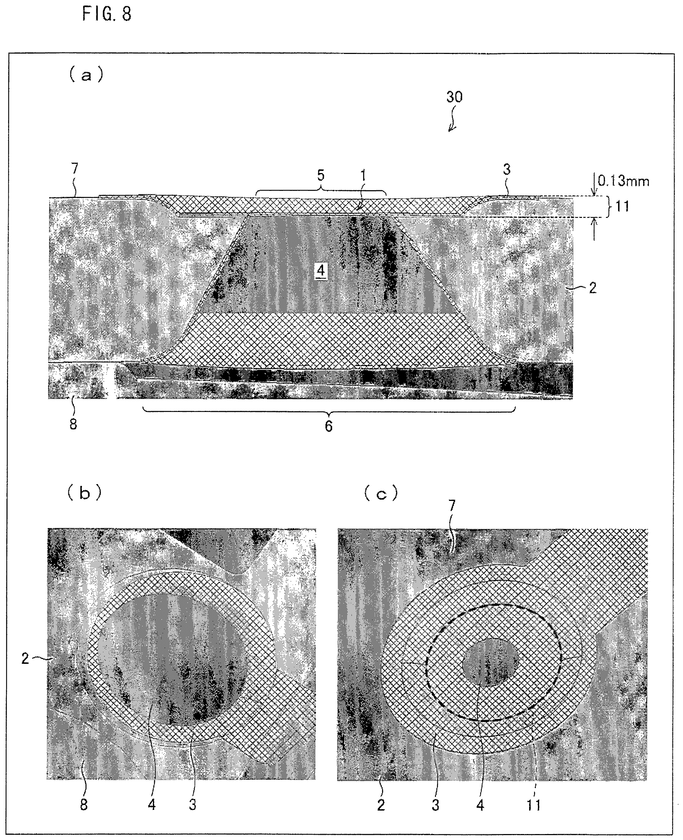

The following discusses an example of the structure according to Embodiment 3, with reference to Figs. 6 to 8. Fig. 6 is a view illustrating one example of the structure according to Embodiment 3. Fig. 7 is an enlarged view of a portion circled in the structure 30 of Fig. 6. Further, (a) of Fig. 8 is a cross sectional view of a plane taken along a broken line in the structure 30 of Fig. 7. (b) of Fig. 8 is a perspective view of a back surface of the structure 30 of Fig. 7. (c) of Fig. 8 is a perspective view of a front surface of the structure 30 of Fig. 7. Note that in Figs. 6 to 8, the molded object 2 is made of a non-conductive (insulating) resin that is made of a mixture of PC, ABS, and glass. Meanwhile, the conduction pattern 3 is made of a plated layer made of copper and nickel. The elastic body 4 is made of adhesive silicone. However, a material for each of the above sections is not limited to the above-described material. Further, the through hole 1 of the structure 30 in Figs. 6 to 8 has a shape tapering from the opening 6 toward the opening 5.

As illustrated in Figs. 6 to 8, the through hole 1 of the structure 30 is arranged to have an inclined inner wall. On an opening 5 side of the through hole 1, a depression 11 is formed. The depression 11 has a thickness (a thickness of a depression from the front surface 7) of 0.13 mm. Note that this thickness of the depression 11 is one example and not limited to this.

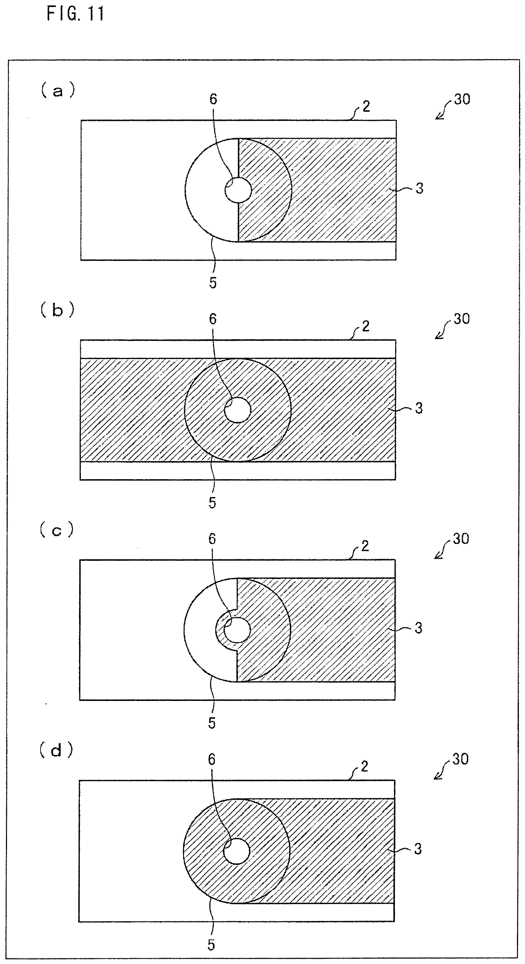

Further, as illustrated in (a) to (c) of Fig. 8, the conduction pattern 3 is provided to all over the inner wall of the through hole 1 as illustrated in (d) of Fig. 11 explained later.

The elastic body 4 and the conduction pattern 3 are adhered to each other by use of an elastic body 4 that is adhesive. This makes it possible to improve a waterproof property.

### (Modified Example)

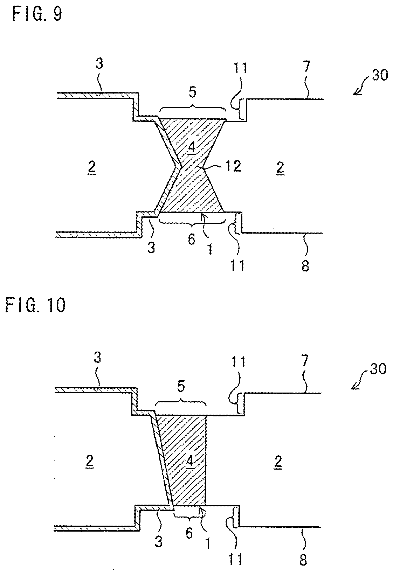

The through hole 1 of the structure 30 according to Embodiment 3 has a shape tapering from the opening 5 toward the opening 6 of the through hole 1. However, the shape of the through hole 1 is not limited to this. Figs. 9 and 10 each are a lateral cross-sectional view illustrating another example of the structure according to Embodiment 3.

As illustrated in Fig. 9, the structure 30 according to Embodiment 3 may have a shape tapering from respective openings toward a minimal width section 12 inside the through hole 1. Further, the inner wall of the through hole 1 in the structure according to Embodiment 3 may have a shape that is inclined all around the inner perimeter of the through hole 1 at the same inclination angle, as illustrated in Fig. 5. Alternatively, as illustrated in Fig. 10, the inner wall of the through hole 1 may have a shape that is inclined only on one side of the through hole 1.

As described above, at least a part of the inner wall of the through hole 1 is formed in a tapering manner. This makes it possible to provide a preferable electrical connection between the front surface 7 and the back surface 8.

### [Others]

(a) to (d) of Fig. 11 each are a view schematically illustrating a variation of a conduction pattern 3. Note that, with reference to (a) to (d) of Fig. 11, the following provides a description on the structure 30, as an example, whose inner wall in the through hole 1 is inclined, so that a location of the conduction pattern 3 is clarified. The same description is applicable to the structure 10 and the structure 20.

The conduction pattern 3 of each of the structures according to Embodiments 1 to 3 is not specifically limited, as long as the conduction pattern 3 is continuously provided from the opening 5 to the opening 6 on the inner wall of the through hole 1. The conduction pattern 3 may be provided only on one side of the through hole 1 as illustrated in Fig. 1 and (a) of Fig. 11. Alternatively, as illustrated in (b) and (d) of Fig. 11, the conduction pattern 3 may be provided all over the through hole 1. As a further alternative, as illustrated in (c) of Fig. 11, the conduction pattern 3 may be provided all around a perimeter of the through hole 1 only in the vicinity of the opening 6.

Further, the depression 11 of each of the structure 10 and the structure 30 may be provided to both or either one of the front surface 7 side and the back surface 8 side.

Further, in the structure 20, the member 21 where the depression 22 or the through hole 23 is formed may be formed on both or either one of the front surface 7 side and the back surface 8 side of the molded object 2.

Further, the elastic body 4 may be provided so as to fully fill the through hole 1 or partially fill the through hole 1.

Further, the elastic body 4 has adhesiveness that makes the elastic body 4 supported by an insulating body. Here, note that the elastic body 4 may be made of a substance having elasticity that produces outward force from the elastic body 4.

In addition, a method of forming the conduction pattern 3 is not limited to an LDS method. The method may be any method as long as the conduction pattern 3 that is continuous from the opening 5 to the opening 6 can be formed by the method. For example, it is possible to employ an MID (Molded Interconnect Devices) method according to which the conduction pattern 3 is formed on an insulating body that is a molded body made of resin or the like.

### (Conclusion)

A structure of the present invention includes: an insulating body having a first through hole; a conductive body electrically connecting two surfaces having respective openings of the first through hole, the conductive body being provided on an inner wall of the first through hole; and a filler being filled in the first through hole, the filler being made of a substance that is deformed by an external pressure more easily than the insulating body.

In the above arrangement, the filler is filled in the first through hole having the inner wall where the conductive body is provided. The filler is made of a substance that is deformed by an external pressure more easily than the insulating body. Accordingly, when an external pressure is applied to the structure, only the filler deforms. Consequently, an excess force is not applied to a contact section between the conductive body and the filler. This makes it possible to prevent the occurrence of a damage such as a crack to the insulating body and the conductive body. Therefore, the structure can maintain an electrical connection between the two surfaces having the respective openings of the first through hole.

Further, preferably, the structure is arranged such that the filler is made of an elastic body.

In to the above arrangement, when an external pressure is applied to the structure, the filler deforms. However, when the external pressure becomes smaller, the shape of the filler can be restored.

Further, preferably, the structure of the present invention is arranged such that a portion of the filler farther from the inner wall of the through hole is arranged to deform more easily than a portion of the filler closer to the inner wall of the through hole, when an external pressure is applied.

In the above arrangement, force concentrates on the portion of the filler which portion is farther from the inner wall of the first through hole, while substantially no force is applied to the portion of the filler which portion is closer to the inner wall of the first through hole. Accordingly, the portion of the filler which portion is closer to the inner wall of the first through hole substantially does not deform. Therefore, a shear is not produced between the conductive body and the filler. Consequently, the conductive body and the filler are not detached from each other. This makes it possible to prevent disconnection of the conductive body. As a result, electrical connection between front and back surfaces of the insulating body can be maintained.

Further, preferably, the structure of the present invention is arranged such that: the insulating body has a first depression that is depressed inward from a surface of the insulating body; and the first through hole has one of the openings in the first depression.

In the above arrangement, when the filler deforms, it is possible to prevent protrusion of the filler from a surface (at least either one of two surfaces) of the insulating body. Therefore, even in a case where an external component is provided in the vicinity of an opening of the first through hole, it is possible to prevent a contact between the external component and the filler.

The structure of the present invention may be arranged to further include: a separate member having a second depression or a second through hole, the separate member being provided so that the second depression or the second through hole faces the first through hole of the insulating body.

In the above arrangement, the separate member has a second depression or a second through hole. This makes it possible to prevent the filler from coming in contact with the separate member at the time when the filler deforms. Preferably, the structure of the present invention may be arranged such that at least a part of the inner wall of the first through hole of the insulating body is formed into a tapering shape.

In the above arrangement, the inner wall of the first through hole is formed into a tapered shape. This allows the filler to be filled in the first through hole more easily. The arrangement also makes it easier to form the conductive body in a finely adjusted manner in the first through hole.

The present invention is not limited to the description of the embodiments above, but may be altered as appropriate by a skilled person within the scope of the claims. That is, the present invention encompasses an embodiment based on a proper combination of technical means modified as appropriate within the scope of the claims.

### Industrial Applicability

The present invention is applicable in an electronics device production field.

### Reference Signs List

- 10, 20, 30: structure
- 1: through hole (first through hole)
- 2: molded object (insulating body)
- 3: conduction pattern (conductive body)
- 4: elastic body (filler)
- 5: opening
- 6: opening
- 7: front surface
- 8: back surface
- 11: depression (first depression)
- 12: minimal width section
- 13: feeding section
- 14: external component
- 21: member (separate member)
- 22: depression (second depression)
- 23: through hole (second through hole)

## Claims

1. A structure (10, 20, 30) comprising:
an insulating body (2) having a first through hole (1);
a conductive body electrically connecting two surfaces (7, 8) having respective openings of the first through hole (1), the conductive body being provided on an inner wall of the first through hole (1); and
a filler (4) being filled in the first through hole,
the filler being made of an elastic body that is deformed by an external pressure more easily than the insulating body (2), wherein a portion of the filler (4) farther from the inner wall of the through hole (1) is arranged to deform more easily than a portion of the filler (4) closer to the inner wall of the through hole (1), when an external pressure is applied, such as the external pressure to cause the filler (4) to deform and protrude in a direction in which the external pressure is applied.

2. The structure (10) as set forth in claim 1, wherein:
the insulating body (2) has a first depression (11) that is depressed inward from a surface of the insulating body (2); and
the first through hole (1) has one of the openings in the first depression, wherein, when an external pressure is applied, the filler (4) protrudes so as to enter into the first depression (11).

3. The structure (20) as set forth in claim 1 or 2, further comprising:
a separate member (21) having a second depression (22),
the separate member (21) being provided so that the second depression (22) faces the first through hole (1) of the insulating body (2).

4. The structure (30) as set forth in any one of claims 1 to 3, wherein at least a part of the inner wall of the first through hole (1) of the insulating body (2) is formed into a shape tapering from a first opening (5) and a second opening (6) toward a minimal width section (12) inside the through hole (1).

## Patentansprüche

1. Struktur (10, 20, 30), umfassend:
einen isolierenden Körper (2) mit einem ersten Durchgangsloch (1);
einen leitenden Körper, der zwei Oberflächen (7, 8) mit jeweiligen Öffnungen der ersten Durchgangslochs (1) elektrisch verbindet, wobei der leitende Körper auf einer inneren Wand des ersten Durchgangslochs (1) vorgesehen ist; und
ein Füllmaterial (4), das in das erste Durchgangsloch gefüllt ist,
wobei das Füllmaterial aus einem elastischen Körper besteht, der durch einen externen Druck leichter verformt wird als der isolierende Körper (2), wobei ein Bereich des Füllmaterials (4), der von der inneren Wand des Durchgangslochs (1) weiter entfernt ist, so eingerichtet ist, dass er sich leichter verformt als ein Bereich des Füllmaterials (4), der der inneren Wand des Durchgangslochs (1) näher ist, wenn ein externer Druck angewendet wird, wie etwa der externe Druck, um zu veranlassen, das sich das Füllmaterial (4) verformt und in einer Richtung hervortritt, in welche der externe Druck angewendet wird.

2. Struktur (10) nach Anspruch 1, wobei:
der isolierende Körper (2) eine erste Vertiefung (11) aufweist, die von einer Oberfläche des isolierenden Körpers (2) nach innen vertieft ist; und
das erste Durchgangsloch (1) eine der Öffnungen in der ersten Vertiefung aufweist, wobei, wenn ein externer Druck angewendet wird, das Füllmaterial (4) so hervortritt, dass es in die erste Vertiefung (11) eintritt.

3. Struktur (20) nach Anspruch 1 oder 2, ferner umfassend:
ein separates Element (21) mit einer zweiten Vertiefung (22),
wobei das separate Element (21) so vorgesehen ist, dass die zweite Vertiefung (22) dem ersten Durchgangsloch (1) des isolierenden Körpers (2) zugewandt ist.

4. Struktur (30) nach einem der Ansprüche 1 bis 3, wobei zumindest ein Teil der inneren Wand des ersten Durchgangslochs (1) des isolierenden Körpers (2) in eine Form ausgebildet ist, die sich von einer ersten Öffnung (5) und einer zweiten Öffnung (6) aus in Richtung eines Abschnitts (12) mit minimaler Breite im Inneren des Durchgangslochs (1) verjüngt.

## Revendications

1. Structure (10, 20, 30) comprenant :
un corps isolant (2) qui présente un premier trou traversant (1) ;
un corps conducteur qui relie électriquement deux surfaces (7, 8) présentant des ouvertures respectives du premier trou traversant (11), le corps conducteur étant prévu sur une paroi intérieure du premier trou traversant (1) ; et
une matière de remplissage (4) qui est placée dans le premier trou traversant,
la matière de remplissage se composant d'un corps élastique qui est déformé par une pression externe plus facilement que le corps isolant (2), une partie de ladite matière de remplissage plus éloignée de la paroi intérieure du trou traversant (1) étant conçue pour se déformer plus facilement qu'une partie de la matière de remplissage (4) plus proche de la paroi intérieure du trou traversant (1), quand une pression externe est appliquée, telle que la pression externe pour amener la matière de remplissage (4) à se déformer et à dépasser dans une direction dans laquelle la pression externe est appliquée.

2. Structure (10) telle qu'elle est présentée dans la revendication 1, dans laquelle :
le corps isolant (2) présente un premier enfoncement (11) qui est formé vers l'intérieur à partir d'une surface du corps isolant (2) ; et
le premier trou traversant (1) présente l'une des ouvertures dans le premier enfoncement, étant précisé que lorsqu'une pression externe est appliquée, la matière de charge (4) dépasse de manière à entrer dans le premier enfoncement (11).

3. Structure (10) telle qu'elle est présentée dans la revendication 1 ou 2, comprenant également :
un élément séparé (21) qui présente un second enfoncement (22),
l'élément séparé (21) étant prévu de telle sorte que le second enfoncement (22) se trouve en face du premier trou traversant (1) du corps isolant (2).

4. Structure (10) telle qu'elle est présentée dans l'une quelconque des revendications 1 à 3, dans laquelle une partie au moins de la paroi intérieure du premier trou traversant (1) du corps isolant (2) a une forme qui va en s'effilant, à partir d'une première ouverture (5) et d'une seconde ouverture (6), vers une section de largeur minimale (12) à l'intérieur du trou traversant (1).
